# EUROPÄISCHE PATENTSCHRIFT

(11) **EP 1 624 740 B1**
(45) Veröffentlichungstag und Bekanntmachung des Hinweises auf die Patenterteilung: **23.09.2009**
(21) Anmeldenummer: 05013421.2
(22) Anmeldetag: 22.06.2005
(51) Int. Cl.: H05K 9/00

(54) **Vorrichtung zur Aufnahme und zur Befestigung eines elektronischen Bauelements auf einer Leiterplatte**
Device for holding and securing an electronic component onto a printed circuit board
Dispositif à retenir et fixer un composant électronique sur une carte de circuit imprimé

(30) Priorität: 05.08.2004 DE 102004038250
(43) Veröffentlichungstag der Anmeldung: 08.02.2006
(73) Patentinhaber: ENDRESS + HAUSER WETZER GmbH + Co. KG, D-87484 Nesselwang (DE)
(72) Erfinder: Härle, Thomas, 87615 Marktoberdorf (DE); Konrad, Michael, 87459 Pfronten (DE); Wöhrle, Markus, 87637 Eisenberg (DE)
(74) Vertreter: Andres, Angelika Maria

(56) Entgegenhaltungen:
- EP-A- 0 702 512
- WO-A-99/43084
- WO-A-03/012856
- DE-U1- 29 505 327

## Beschreibung

Die Erfindung betrifft eine Vorrichtung zur Aufnahme und zur Befestigung eines elektronischen Bauelements auf einer Leiterplatte.

Auf einer Leiterplatte befestigte elektronische Bauelemente, insbesondere wenn es sich um frequenzbestimmende Bauelemente wie Resonatoren oder Quarze handelt, weisen üblicherweise eine relativ geringe Störfestigkeit auf. Darüber hinaus hat die Störausstrahlung dieser Bauelemente u. U. einen negativen Einfluss auf in der näheren Umgebung angeordnete elektronische Bauelemente oder Schaltungsteile.

Ausgestaltungen zur Abschirmung von Schaltungen sind im Stand der Technik bekannt: Der Patentschrift DE 43 27 766 C2 lässt sich eine Schaltungsanordnung entnehmen, in welcher mehrere Bauteile von einem Leiterbahnring umgeben sind. Spezielle Ausgestaltungen von Abschirmboxen oder Metallkappen, welche Bauteile für den Zweck der Abschirmung umgeben, lassen sich den Offenlegungsschriften DE 101 34 152 A1 und DE 43 17 469 A1 oder der Gebrauchsmusterschrift DE 295 05 327 U1 entnehmen, wobei DE 295 05 3274U1 die Merkmale des ersten Teils des Anspruchs 1 offenbart.

Der Erfindung liegt die Aufgabe zugrunde, eine Vorrichtung vorzuschlagen, die ein elektronisches Bauelement einerseits effektiv gegen störende Einflüsse aus der Umgebung schützt und die andererseits störende Einflüsse des elektronischen Bauelements auf die Umgebung weitgehend unterbindet.

Die Aufgabe wird durch eine erfindungsgemäße Vorrichtung gemäß Anspruch 1 gelöst. In einer Ausgestaltung besteht die Vorrichtung aus einem Gehäuse, das eine Bodenfläche, eine auf die Form der Bodenfläche angepasste Anzahl von Seitenflächen und eine entsprechende Deckfläche aufweist. Hierbei ist die Deckfläche aus einem elektrisch leitenden Material gefertigt. Weiterhin ist zumindest ein elektrisch leitendes Verbindungselement vorgesehen, das so ausgebildet und/oder angeordnet ist, dass eine oberhalb der Deckfläche befindliche Abdeckfläche über das Verbindungselement auf einem vorgegebenen Bezugspotential liegt. Bevorzugt handelt es sich um das Bezugspotential der Leiterplatte. Durch diese erfindungsgemäße Ausgestaltung lässt sich die Störfestigkeit eines empfindlichen elektronischen Bauelements ohne großen Aufwand und ohne große Zusatzkosten wirkungsvoll verbessern. Weiterhin wird eine Störstrahlung, die das elektronische Bauelement in die Umgebung ausstrahlt, deutlich reduziert. Dieser zuletzt genannte Aspekt ist von großer Bedeutung, wenn es sich - wie gemäß einer vorteilhaften Weiterbildung der erfindungsgemäßen Vorrichtung vorgeschlagen wird - bei dem elektronischen Bauelement um ein frequenzbestimmendes Bauelement, z. B. um einen Resonator oder einen Quarz, handelt. Gleiches gilt, wenn es sich bei dem elektronischen Bauelement um einen Mikroprozessor handelt.

Gemäß einer vorteilhaften Weiterbildung der erfindungsgemäßen Vorrichtung ist eine isolierende Zwischenschicht vorgesehen, die die Abdeckfläche elektrisch von den Seitenflächen isoliert. Diese Ausgestaltung ist zur Unterbindung eines Kurzschlusses erforderlich, wenn die Seitenflächen aus einem elektrisch leitenden Material gefertigt sind. Sie ist nicht zwingend notwendig, wenn die Seitenflächen aus einem elektrisch nicht leitenden Material bestehen. Die Variante, dass das Gehäuse komplett aus einem leitfähigen Material gefertigt ist, hat den Vorteil, dass zusätzlich zu der bereits zuvor beschriebenen Erhöhung der Störfestigkeit und der Reduzierung der Störausstrahlung des elektronischen Bauelements der thermische Widerstand des elektronischen Bauelements erheblich reduziert wird. Dies führt zu einer besseren Wärmeableitung des elektronischen Bauelements, so dass die Gefahr einer Überhitzung und einer vorzeitigen Alterung des elektronischen Bauelements minimiert ist.

Eine bevorzugte Ausgestaltung der erfindungsgemäßen Vorrichtung schlägt vor, dass es sich bei dem Verbindungselement um eine Lötfahne handelt, die bei der Montage des elektronischen Bauelements auf der Leiterplatte mit einer Leiterbahn der Leiterplatte verlötbar ist. Durch diese Maßnahme ist sichergestellt, dass das Gehäuse auf dem Bezugspotential der Leiterplatte liegt. Somit werden die Störeinflüsse auf das elektronische Bauelement ebenso wie die Störausstrahlung des elektronischen Bauelements in die Umgebung effektiv unterbunden.

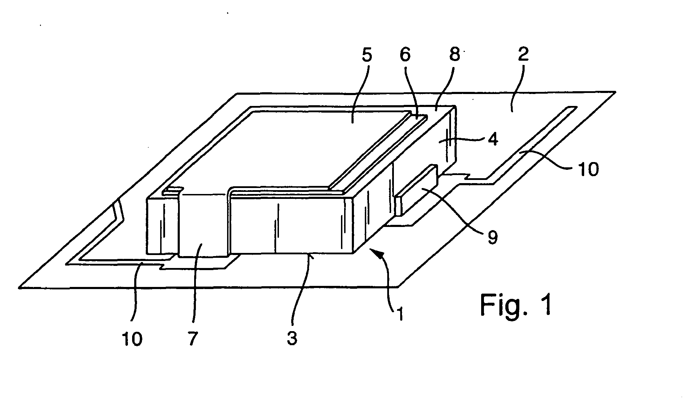

Die Erfindung wird anhand der Fig. 1 näher erläutert. Fig. 1 zeigt eine bevorzugte Ausführungsform der erfindungsgemäßen Vorrichtung. In dem Gehäuse 1 ist das elektronische Bauelement 9 untergebracht. Wie bereits erwähnt, handelt es sich bei dem elektronischen Bauelement 9 beispielsweise um ein frequenzbestimmendes Bauelement oder um einen Mikroprozessor.

Das quaderförmige Gehäuse 1 setzt sich im gezeigten Fall aus einer Bodenfläche 3, vier Seitenflächen 4 und einer Deckfläche 8 zusammen. An der rechten Seitenfläche 4 des Gehäuses 1 ist ein Bauteilpin zum elektrischen Anschluss des elektronischen Bauelements 9 an eine Leiterbahn 10 der Leiterplatte 2 vorgesehen.

Da die Deckfläche 8 des Gehäuses 1 im gezeigten Fall aus einem elektrisch leitenden Material gefertigt ist, ist eine isolierende Zwischenschicht 6 zwischen der Deckfläche 8 und der Abdeckfläche 5 angeordnet. Die Abdeckfläche 5 ist mit einer Leiterbahn 10 der Leiterplatte 2 elektrisch über das Verbindungselement 7 verbunden. Dudurch wird praktisch ein Kondensator geschaffen, dessen Elektroden die Deckfläche 8 und die Abdeckfläche 5 sind. Bei dem Verbindungselement 7 handelt es sich bevorzugt um eine Lötfahne. Über die elektrische Kontaktierung liegt die Abdeckfläche 5 bzw. das Gehäuse 1 auf dem Bezugspotential der Leiterplatte 2. Bei dem Bezugspotential handelt es sich bevorzugt um Massepotential.

Durch die erfindungsgemäße Ausgestaltung lässt sich die Störfestigkeit eines empfindlichen elektronischen Bauelements 9 ohne großen Aufwand sehr wirkungsvoll verbessern. Weiterhin lässt sich die Störausstrahlung des elektronischen Bauelements 9 in die Umgebung deutlich reduzieren. Dieser zuletzt genannte Aspekt ist von großer Bedeutung, wenn es sich - wie bereits erwähnt - gemäß einer vorteilhaften Weiterbildung der erfindungsgemäßen Vorrichtung bei dem elektronischen Bauelement 9 um ein frequenzbestimmendes Bauelement, z. B. einen Resonator oder einen Quarz, handelt. Gleiches gilt, wenn es sich bei dem elektronischen Bauelement beispielsweise um einen Mikroprozessor handelt. Darüber hinaus wird durch die erfindungsgemäße elektrische Abkapselung des Bauelements von der Umgebung der thermische Widerstand des elektronischen Bauelements erheblich reduziert. Dies führt zu einer besseren Wärmeableitung des elektronischen Bauelements, so dass der Gefahr einer Überhitzung des elektronischen Bauelements entgegengewirkt wird.

## Patentansprüche

1. Vorrichtung zur Aufnahme und zur Befestigung eines elektronischen Bauelements (9) auf einer Leiterplatte (2),
mit einem Gehäuse (1), welches Seitenflächen (4) und eine entsprechende Deckfläche (8), welche aus einem elektrisch leitenden Material gefertigt ist,
aufweist,
**dadurch gekennzeichnet,**
**dass** eine Abdeckfläche (5) vorgesehen ist,
**dass** eine isolierende Zwischenschicht (6) vorgesehen ist, welche die Abdeckfläche (5) elektrisch von der Deckfläche (8) isoliert,
und
**dass** zumindest ein elektrisch leitendes Verbindungselement (7) vorgesehen ist, welches so ausgebildet und/oder angeordnet ist, dass die Abdeckfläche (5) über das Verbindungselement (7) auf einem Bezugspotential der Leiterplatte (2) liegt.

2. Vorrichtung nach Anspruch 1,
wobei die isolierende Zwischenschicht (6) die Abdeckfläche (5) elektrisch von den Seitenflächen (4) und der Deckfläche (8) isoliert.

3. Vorrichtung nach Anspruch 1,
wobei es sich bei dem Verbindungselement (7) um eine Lötfahne handelt, die bei der Montage des elektronischen Bauelements (9) auf der Leiterplatte (2) mit einer Leiterbahn (10) der Leiterplatte (2) verlötbar ist.

4. Vorrichtung nach Anspruch 1,
wobei es sich bei dem elektronischen Bauelement (9) um ein frequenzbestimmendes Bauelement handelt.

5. Vorrichtung nach Anspruch 4,
wobei es sich bei dem frequenzbestimmenden Bauelement um einen Resonator oder um einen Quarz handelt.

6. Vorrichtung nach Anspruch 1,
wobei es sich bei dem elektronischen Bauelement (9) um einen Mikroprozessor handelt.

7. Vorrichtung nach Anspruch 1,
wobei das Gehäuse (1) eine Bodenfläche (3) aufweist.

8. Vorrichtung nach Anspruch 7,
wobei die Anzahl der Seitenflächen (4) an die Form der Bodenfläche (3) angepasst ist.

9. Vorrichtung nach Anspruch 1,
dass die Abdeckfläche (5) oberhalb der Deckfläche (8) angeordnet ist.

## Claims

1. Unit for holding and securing an electronic component (9) on a printed circuit board (2), with a housing (1) exhibiting sides (4) and a corresponding top surface (8), which is made of an electrically conductive material,
**characterized in that**:
- a cover surface (5) is provided
- an isolating intermediate layer (6) is provided, which electrically isolates the cover surface (5) from the top surface (8)
- at least one electrically conductive connecting element (7) is provided which is designed and/or arranged in such a way that the cover surface (5) lies on a reference potential of the PCB (2) via the connecting element (7).

2. Unit as per Claim 1, where the isolating intermediate layer (6) electrically isolates the cover surface (5) from the sides (4) and the top surface (8).

3. Unit as per Claim 1, where the connecting element (7) is a soldering lug, which can be soldered to a strip conductor (10) of the circuit board (2) when mounting the electronic component (9) on the circuit board (2).

4. Unit as per Claim 1, where the electronic component (9) is a frequency-determining component.

5. Unit as per Claim 4, where the frequency-determining component is a resonator or a quartz crystal.

6. Unit as per Claim 1, where the electronic component (9) is a microprocessor.

7. Unit as per Claim 1, where the housing (1) exhibits a floor surface (3).

8. Unit as per Claim 7, where the number of sides (4) is adapted to the shape of the floor surface (3).

9. Unit as per Claim 1, **characterized in that** the cover surface (5) is arranged above the top surface (8).

## Revendications

1. Dispositif destiné au logement et à la fixation d'un composant électronique (9) sur un circuit imprimé (2),
avec un boîtier (1) comportant des surfaces latérales (4) et une surface de recouvrement (8), laquelle est fabriquée en un matériau électroconducteur,
**caractérisé en ce**
**qu'**est prévue une surface de couverture (5),
**qu'**est prévue une couche intermédiaire isolante (6), laquelle isole la surface de couverture (5) électriquement de la surface de recouvrement (8),
et
**qu'**est prévu au moins un élément de liaison (7) électroconducteur, lequel est conçu et/ou disposé de telle sorte que la surface de couverture repose au-dessus de l'élément de liaison (7) sur un potentiel de référence du circuit imprimé (2).

2. Dispositif selon la revendication 1,
pour lequel la couche intermédiaire isolante (6) isole la surface de couverture (5) électriquement des surfaces latérales (4) et de la surface de recouvrement (8).

3. Dispositif selon la revendication 1,
pour lequel, concernant l'élément de liaison (7), il s'agit d'une broche à souder, qui peut être soudée lors du montage du composant électronique (9) sur le circuit imprimé (2) avec la piste conductrice (10) du circuit imprimé (2).

4. Dispositif selon la revendication 1,
pour lequel, concernant le composant électronique (9), il s'agit d'un composant déterminant la fréquence.

5. Dispositif selon la revendication 4,
pour lequel, concernant le composant déterminant la fréquence, il s'agit d'un résonateur ou d'un quartz.

6. Dispositif selon la revendication 1,
pour lequel, concernant le composant électronique (9), il s'agit d'un microprocesseur.

7. Dispositif selon la revendication 1,
pour lequel le boîtier (1) comporte un fond (3).

8. Dispositif selon la revendication 7,
pour lequel le nombre de faces latérales (4) est adapté à la forme du fond (3).

9. Dispositif selon la revendication 1,
pour lequel la surface de couverture (5) est disposée au-dessus de la surface de recouvrement (8).
